(19) **Europäisches Patentamt**

**European Patent Office**

**Office européen des brevets**

(11) **EP 1 109 028 B1**

(12) **EUROPÄISCHE PATENTSCHRIFT**

(45) Veröffentlichungstag und Bekanntmachung des Hinweises auf die Patenterteilung:
**10.08.2005 Patentblatt 2005/32**

(51) Int Cl.$^7$: **G01R 31/36**

(21) Anmeldenummer: **00123604.1**

(22) Anmeldetag: **28.10.2000**

(54) **Verfahren zur Überwachung der Restladung und der Leistungsfähigkeit einer Batterie**

Monitoring the residual charge of a battery

Contrôle de la charge résiduelle d'une batterie

(84) Benannte Vertragsstaaten:
**FR GB IT**

(30) Priorität: **16.12.1999 DE 19960761**

(43) Veröffentlichungstag der Anmeldung:
**20.06.2001 Patentblatt 2001/25**

(73) Patentinhaber: **DaimlerChrysler AG**
**70567 Stuttgart (DE)**

(72) Erfinder:
• **Schöner, Hans-Peter, Dr.**
**64397 Modautal (DE)**
• **Blessing, Alf, Dr.**
**73092 Heiningen (DE)**

(56) Entgegenhaltungen:
**US-A- 5 151 865**     **US-A- 5 744 931**
**US-A- 5 789 923**     **US-A- 5 828 218**

**Beschreibung**

Die Erfindung betrifft ein Verfahren nach dem Oberbegriff des unabhängigen Anspruchs.

Bekannt sind Batterieüberwachungssysteme, die den Ladungszustand der Batterie im stromlosen Zustand der Batterie ermitteln. Derartige Systeme nutzen die weitgehend lineare Abhängigkeit der Ruhespannung von der Säuredichte des Elektrolyten. Diese Säuredichte ändert sich proportional zur Ladungsmenge, die der Batterie bereits entnommen wurde. Diese Systeme können den Ladezustand der Batterie ermitteln, wenn die Batterie mehrere Stunden stromlos war und die internen Diffusionsvorgänge zur Ruhe gekommen sind.

Weiterhin ist aus Steffens,W. "Verfahren zur Schätzung der Inneren Größen von Starterbatterien", Dissertation RWTH Aachen 1987, bekannt, aus einer Modelbetrachtung Batteriezustandsgrößen zu schätzen. Diese Batteriezustandsgrößen umfassen u.a. auch die Ruhespannung der Batterie. Dieses Modell arbeitet zwar im strombelasteten Zustand der Batterie, erlaubt jedoch keine Aussage über den verbliebenen Energieinhalt der Batterie. Außerdem ist die Modellbildung sehr komplex und hat sich daher in der Praxis nicht durchgesetzt Erfindungsgemäße Aufgabe ist es daher, ein Verfahren zur Batterieüberwachung anzugeben, das zum einen die Batterieüberwachung ohne die Einhaltung von Ruhepausen erlaubt und zum anderen gleichzeitig die Ermittlung des restlichen Energieinhalts der Batterie ermöglicht.

Erfindungsgemäß wird diese Aufgabe gelöst durch die Merkmale des unabhängigen Anspruchs. Weitere vorteilhafte Ausführungsformen sind in den Unteransprüchen enthalten.

Erfindungsgemäß gelingt dies, indem an der belasteten Batterie mindestens zwei Strom-Spannungsmessungen durchgeführt werden. Die Strombelastung der Batterie ist hierbei größer als 30 % der Nennkapazität pro Stunde, z.B. bei einer 100 Ah-Batterie mindestens 30 Ampere, zu wählen. Die erste Strom-Spannungsmessung wird zu einem ersten Zeitpunkt bei einem ersten Belastungszustand der Batterie gemessen. Eine zweite Strom-Spannungmessung wird zu einem zweiten Zeitpunkt bei einem zweiten Belastungszustand der Batterie durchgeführt. Wesentlich ist, daß sich hierbei der Belastungszustand der Batterie durch den entnommenen Strom geändert hat. Die Stromspannungsmessungen ergeben einen ersten Meßpunkt und einen zweiten Meßpunkt. Durch die beiden Meßpunkte wird eine Interpolationsgerade gelegt und deren Schnittpunkt mit einem Grenzspannungsniveau ($U_{Gr}$) ermittelt. Dieser Schnittpunkt ist gekennzeichnet durch einen sogenannten Grenzstrom ($I_{Gr}$). Das Grenzspannungsniveau ist bestimmt aus der Mindestspannung, die die angeschlossenen Verbraucher benötigen, um fehlerfrei zu funktionieren. Das Grenzspannungsniveau wird daher bei der technischen Auslegung des Batterienetzes vorgegeben und ist bekannt. Die fehlerfreie Funktion der angeschlossenen Verbraucher erfordert weiterhin einen Mindestbetriebsstrom ($I_{min}$), der als Auslegeparameter des Batterienetzes ebenfalls festgelegt und bekannt ist. Die Differenz aus ermitteltem Grenzstrom $I_{Gr}$ und Mindestbetriebsstrom $I_{min}$ wird ermittelt und festgehalten. Diese Differenz ist ein Maß für die noch verfügbare Restladung der Batterie und wird hier erfindungsgemäß mit Grenzstromreserve bezeichnet.

Mit der Erfindung werden hauptsächlich die folgenden Vorteile erzielt:

Die Grenzstromreserve kann aus einer mit Strom belasteten Batterie ermittelt werden. Damit kann auch eine Batterieüberwachung durchgeführt werden an Systemen, die kontinuierlich betrieben werden und somit keine Ruhespannungsmessung an der Batterie erlauben. Im Bereich der Kraftfahrzeuge ist ein solches System z.B. ein Taxi, das 24 h pro Tag im Einsatz ist. Bei einem derartigen Taxi versagen herkömmliche Batterieüberwachungssysteme. Der Taxifahrer bekommt keine Information über ein bevorstehendes Zusammenbrechen seines Bordnetzes und damit über den Ausfall vieler relevanter Sicherheitsvorrichtungen wie Antiblokkiersysteme, Airbags, Elektronische Stabilisierungsprogramme, Gurtstraffer, Niveauregulierungen u.s.w.. Die herkömmliche Ladestromkomtrolleuchte macht bekanntlich nur Aussagen über die Stromrichtung zwischen Generator und Batterie. Die Ladestromkontrolleuchte erlaubt jedoch keine Zustandsdiagnose über einen bevorstehenden Zusammenbruch des Bordnetzes oder darüber, ob für die sicherheitsrelevanten Systeme noch genügend Energie zur Verfügung steht. Dies wird erst mit dem erfindungsgemäßen Verfahren möglich.

Die Grenzstromreserve berücksichtigt in einem einzigen Maß die für eine Batteriediagnose relevanten Einflüsse wie Batterietemperatur, mittlerer Entladestrom der Batterie und Batteriealterungszustand.

Die Grenzstromreserve wird nicht beeinflußt durch Diffusionsvorgänge oder andere Nichtlinearitäten der Batterie, welche bei kleinen Entladeströmen die Batterispannungslage stark beeinflussen, und ermöglicht daher eine zuverlässige und quantitfizierbare Aussage über die Restladung der Batterie.

Durch die Ermittlung der Grenzstromreserve mit Hilfe des Grenzstromes ($I_{Gr}$) wird die Batterieleistungsfähigkeit im Grenzbereich der Funktionsfähigkeit des angeschlossenen Verbrauchersystems bewertet. Die Grenzstromreserve erlaubt daher eine Sicherheitsabschätzung, daß das angeschlossene Verbrauchersystem auch bei kritischen Belastungszuständen nicht versagen wird. Dies ist besonders im Hinblick auf die bereits erwähnten sicherheitsrelevanten Vorrichtungen in einem Kraftfahrzeug von großem Vorteil, da deren voraussichtlich einwandfreie Funktion mit der Grenzstromreserve zuverlässig prognostiziert wird.

Weiterhin erlaubt das erfindungsgemäße Verfahren durch die Produktbildung aus Grenzspannungsniveau ($U_{Gr}$) und Grenzstrom ($I_{Gr}$), die Angabe einer maximalen Leistung, die der Batterie noch entnommen werden kann, ohne das Grenzspannungsniveau zu unterschreiten.

Im folgenden werden Ausführungsbeispiele der Erfindung unter anderem anhand von einer Zeichnung dargestellt und näher erläutert. Es zeigen:

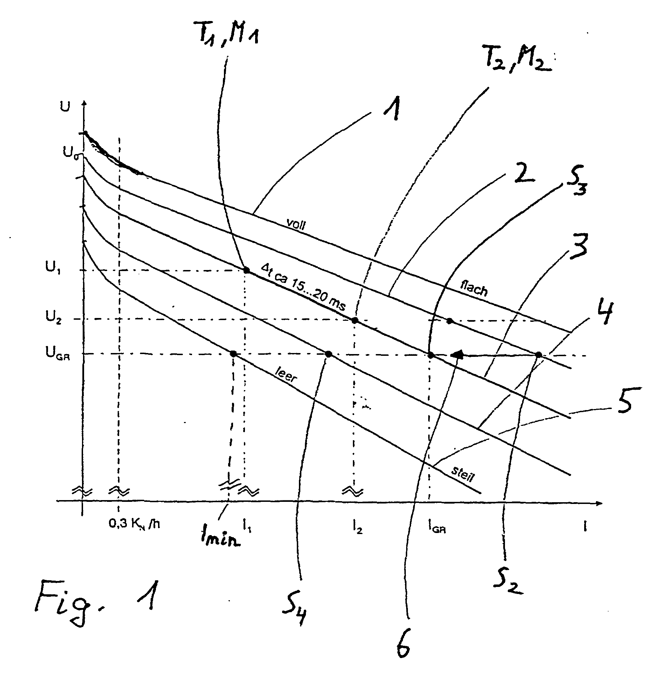

Fig. 1     eine schematische Darstellung des Zusammenhangs zwischen Grenzspannungsniveau ($U_{Gr}$), Grenzstrom ($I_{Gr}$) und den Strom-Spannungskennlinien der Batterie, bei verschiedenen Ladezuständen der Batterie

Anhand von Fig. 1 wird im folgenden die Erfindung und insbesondere die Grenzstromreserve beispielhaft erläutert. In Fig. 1 ist eine typische Strom-Spannungs-Kennlinienschar einer Batterie mit verschiedenen Ladezuständen dargestellt. Mit der Ziffer 1 wird eine Kennlinie für eine vollgeladene Batterie bezeichnet. Die Kennlinie 1 einer vollgeladenen Batterie zeichnet sich durch einen flachen Verlauf aus. D.h die Spannung U an den Klemmen der Batterie nimmt mit zunehmendem Laststrom I verhältnismäßig gering ab. Mit zunehmender Entladung der Batterie oder zunehmender Alterung der Batterie nehmen die Strom-Spannungskennlinien 2,3,4,5 einen immer steileren Verlauf, bis schließlich die Strom-Spannungs-Kennlinie 5 das Grenzspannungsniveau $U_{Gr}$ beim Mindeststrom $I_{min}$ schneidet. Eine Batterie in diesem Zustand wird als leer bezeichnet. Zur Ermittlung der Grenzstromreserve einer Batterie mit einem Ladezustand, der der Kennlinie 3 entspricht, wird folgendermaßen vorgegangen.

Eine erste Strom-Spannungsmessung wird zu einem ersten Zeitpunkt $T_1$ bei einem ersten Belastungszustand der Batterie gemessen. Eine zweite Strom-Spannungmessung wird zu einem zweiten Zeitpunkt $T_2$ bei einem zweiten Belastungszustand der Batterie durchgeführt. Wesentlich ist, daß sich hierbei der Belastungszustand der Batterie durch den entnommenen Strom geändert hat. Außerdem muß der Laststrom der Batterie größer als 30% der Nennkapazität $K_N$ pro Stunde gewesen sein. Die Stromspannungsmessungen ergeben einen ersten Meßpunkt $M_1$ und einen zweiten Meßpunkt $M_2$. Durch die beiden Meßpunkte $M_1$, $M_2$ wird eine Interpolationsgerade 3 gelegt und deren Schnittpunkt $S_3$ mit einem Grenzspannungsniveau $U_{Gr}$ ermittelt. Dieser Schnittpunkt ist gekennzeichnet durch einen sogenannten Grenzstrom $I_{Gr}$. Das Grenzspannungsniveau ist bestimmt aus der Mindestspannung, die die angeschlossenen Verbraucher benötigen, um fehlerfrei zu funktionieren. Das Grenzspannungsniveau wird daher bei der technischen Auslegung des Batterienetzes vorgegeben und ist bekannt. Die fehlerfreie Funktion der angeschlossenen Verbraucher erfordert weiterhin einen Mindestbetriebsstrom $I_{min}$, der als Auslegeparameter des Batterienetzes ebenfalls festgelegt und bekannt ist. Die Differenz aus ermitteltem Grenzstrom $I_{Gr}$ und Mindestbetriebsstrom $I_{min}$ wird ermittelt und festgehalten. Diese Differenz ist ein Maß für die noch verfügbare Restladung der Batterie und wird hier erfindungsgemäß mit Grenzstromreserve bezeichnet. In gleicher Weise lassen sich aus den Kennlinien 2 und 4 die Schnittpunkte $S_2$ und $S_4$ bestimmen. Man erkennt, daß mit zunehmender Entladung der Batterie die Schnittpunkte $S_2$, $S_3$, $S_4$ immer weiter nach links hin zum Mindestbetriebsstrom $I_{min}$ wandern, symbolisch dargestellt durch den Pfeil 6. Die erfindungsgemäß ermittelte Grenzstromreserve gibt also den abnehmenden Ladezustand der Batterie richtig wieder. Insbesondere erreicht die Grenzspannung den Wert 0, wenn der Grenzstrom $I_{Gr}$ mit dem Mindeststrom $I_{min}$ zusammenfällt, wie es für die Kennlinie 5 der Fall ist. Damit ergibt die Grenzspannungsreserve für eine definitionsgemäß leere Batterie den Wert 0.

Typischer Weise sind die beiden Meßpunkte $M_1$ und $M_2$ zu zwei Zeitpunkten aufgenommen, die ca 15 bis 20 ms auseinander liegen.

In einem anderen erfindungsgemäßen Ausführungsbeispiel wird die Grenzstromreserve ermittelt, indem die jeweils aktuelle Strom-Spannungskennlinie der Batterie durch eine Vielzahl von Strom-Spannungsmessungen bei unterschiedlichen Belastungszuständen aufgenommen wird. Durch diese Vielzahl von Meßpunkten wird dann eine Ausgleichsgerade, z.B. durch an sich bekannte Regressionsverfahren, gelegt und der Grenzstrom wieder als Schnittpunkt dieser Ausgleichsgeraden mit dem Grenzspannungsniveau bestimmt.

In einem anderen Ausführungsbeispiel wird die Grenzstromreserve aus der kontinuierlichen Beobachtung der Strom-Spannungskennlinie der Batterie bestimmt. Hierzu können an sich bekannte sogenannte Zustandsbeobachter, z.B. Lüenberger-Beobachter oder Kalman-Filter, eingesetzt werden. Diese Zustandsbeobachter bestimmen die Steigung und den Ordinatenabschnitt der Ausgleichsgeraden für die Strom-Spannungskennlinie. Die Grenzstromreserve wird wieder wie vorbeschrieben aus dem Schnittpunkt dieser Ausgleichsgeraden mit dem Grenzspannungsniveau bestimmt. Besonders vorteilhaft bei diesem Ausführungsbeispiel ist es, daß der Grenzstrom und damit die Grenzstromreserve stets für den augenblicklichen Batteriezustand ermittelt werden, also in Echtzeit.

Bei allen Ausführungsbeispielen kann aus der Grenzstromreserve auf die Restladung $Q_{Rest}$ der Batterie geschlossen werden. Im einfachsten Fall unterstellt man einen linearen Zusammenhang zwischen Grenzstromreserve und Restladung der Batterien. Die Restladung 0 wird erreicht, wenn die Grenzstromreserve den Wert 0 hat. Die volle Ladung der Batterie entspricht der Grenzstromreserve, welche an einer vollgeladenen Batterie unter festgelegten Nennbedingungen (z.B. bezgl. der Temperatur) ermittelt wird. Durch Bestimmung der jeweils aktuellen Grenzstromreserve und Vergleich mit den beiden zuvor genannten und bestimmten Randwerten ergibt sich ein Maß für den aktuellen Ladezustand der Batterie. Bei Unterstellung eines linearen Zusammenhangs zwischen Grenzstromreserve und Restladung $Q_{Rest}$ gibt der Quotient aus aktueller Grenzstromreserve und der Grenzstromreserve für die vollgeladene Batterie den aktuellen Ladezustand der Batterie in Anteilen der vollen Ladung an.

Eine genauere Ermittlung der Restladung der Batterie aus der Grenzstromreserve ergibt sich aus folgender Relation

$$Q_{Rest} \geq \frac{(I_{Gr} - I_{min})}{\left(\dfrac{dI_{Gr}}{dQ}\right)_{max}}$$

$$Q_{Rest} \geq \frac{\text{Grenzstromreserve}}{\text{maximale Grenzstromsteigung}}$$

Hierbei wird die maximale Grenzstromsteigung

$$\left(\frac{dI_{Gr}}{dQ}\right)_{max}$$

experimentell ermittelt. Die Grenzstromsteigung ist eine Kenngröße der Batterie. Die Grenzstromsteigung wird bestimmt aus einer Vielzahl von Belastungsmessungen, zu denen jeweils die Grenzströme bestimmt werden. Von einer Belastungsmessung zur nächsten Belastungsmessung wird die Batterie jeweils um eine definierte Ladungsmenge entladen und für jeden Ladezustand der Grenzstrom ermittelt. Die ermittelten Grenzströme werden über die entnommene Ladungsmenge aufgetragen und die so erhaltenen Meßpunkte mit einer Kurve angenähert. Die maximale Steigung der Kurve ergibt dann die hier bezeichnete maximale Grenzstromsteigung.

Nach den zuvor angeführten Relationen ergibt sich dann eine Mindestabschätzung für die Restladug $Q_{Rest}$, die noch in der Batterie zur Verfügung steht. Demnach ist die Restladung der Batterie größer oder gleich als die Ladungsmenge, die durch den Quotienten aus der Grenzstromreserve und der maximalen Grenzstromsteigung gegeben ist.

Bei konstanter Belastung der Batterie kann aus der Restladung $Q_{Rest}$ auf die noch zur Verfügung stehende Restentladezeit geschlossen werden, indem man die Restladung durch den anliegenden Laststrom dividiert. Aus dem Vergleich der Restentladezeit mit einer für eine bestimmte Funktion notwendigen Mindestentladezeit kann mit Vorteil abgeleitet werden, wie lange die Batterie mit ihrem aktuellen Ladezustand in der Lage ist, die notwendige Energie für die aktuell angeschlossenen Verbraucher zu liefern. Dies ist insbesondere von großem Vorteil, wenn in Kraftfahrzeugen das ordnungsgemäße Funktionieren der bereits exemplarisch aufgeführten Sicherheitsfunktionen gewährleistet werden muß.

Bei allen Ausführungsbeispielen ist die Genauigkeit der Berechnung des Grenzstroms von entscheidender Bedeutung. Diese Genauigkeit ist umso höher je größer der Unterschied im Laststrom zwischen der ersten Messung zur Bestimmung der Grenzstromreserve und der zweiten Messung zur Bestimmung der Grenzstromreserve ist. Mit anderen Worten sind Betriebszustände, bei denen große Belastungswechsel der Batterie und damit große Stromänderungen auftreten, besonders vorteilhaft, um die erfindungsgemäßen Ausführungsbeispiele durchzuführen. Derartige große Belastungswechsel treten bei Kraftfahrzeugen z.B. während des Startvorgangs auf. Die erfindungsgemäßen Ausführungsbeispiele werden daher in besonders vorteilhafter Weise beim Start eines Kraftfahrzeuges ausgeführt.

Weiterhin sind große Belastungswechsel im Bordnetz eines Kraftfahrzeuges durch kurzzeitiges Ein- bzw. Ausschalten von leistungsstarken Verbrauchern möglich. Große Belastungswechsel rufen z.B. Ein- und Auschaltvorgänge von Heizverbrauchern (Heckscheibe, Zusatzheizung im Kühlkreislauf, heizbare Sitze, Standheizung...) hervor. Die Bestimmung der Grenzstromreserve und der Restladung der Batterie, der Restentladezeit oder der Mindestladezeit erfolgt dann wie vorbeschrieben.

Eine weitere Möglichkeit große Belastungswechsel und damit verschiedene Belastungszustände im Bordnetz eines Kraftfahrzeuges gezielt durch Schaltvorgänge hervorzurufen, ist das kurzzeitige Ausschalten des Bordnetzgenerators oder die Variation der Generatorerregung. Die Veränderung der Generatorspannung hat gegenüber dem Ein- und Ausschalten von Verbrauchern den Vorteil, daß auf das Einschalten einer zusätzlichen evtl. nicht benötigten oder nicht gewünschten Funktion verzichtet werden kann, um einen Belastungswechsel im Bordnetz gezielt zu bewirken. So braucht bei der Veränderung der Generatorspannung z.B. im Sommer an heißen Tagen keine Zusatzheizung eingeschaltet werden, nur um einen Belastungswechsel hervorzurufen. Die Bestimmung der Grenzstromreserve und der Restladung der Batterie, der Restentladezeit oder der Mindestladezeit erfolgt dann wie vorbeschrieben.

Im Einzelfall kann es auch von Vorteil einen mehrstufigen Belastungswechsel im Bordnetz eines Kraftfahrzeugs gezielt hervorzurufen. Ein mehrstufuger Belastungswechsel ist insbesondere dann von Nutzen, wenn zur Bestimmung der Grenzstromreserve die Ausgleichskurve der Strom-Spannungskennlinie der Batterie aus einer Vielzahl von Meßpunkten aufgenommen werden soll. In diesem Fall wird für jeden Belastungszustand jeweils ein Meßpunkt der Strom-Spannungskennlinie aufgenommen. Die Anzahl der möglichen Meßpunkte ist hier von der Anzahl der gezielt hervorrufbaren Belatungszuständen abhängig. Um eine möglichst große Anzahl von Meßpunkten aufnehmen zu können ist deshalb von Vorteil die beiden zuvorbeschriebenen Möglichkeiten, nämlich die Variation der Generatorspannung und das Ein- und Ausschalten von Verbrauchern, zu kombinieren, da damit die Anzahl der möglichen Belastungswechsel und Belastungszustände die zur Bestimmung der erfindungsgemäßen Batteriekenngrößen herangezogen werden können, am gößten ist. Die Bestimmung der Grenzstromreserve und der Restladung der Batterie, der Restentladezeit oder der Mindestladezeit erfolgt dann wie vorbeschrieben.

**Patentansprüche**

1. Verfahren zur Überwachung der Restladung und der Leistungsfähigkeit einer belasteten Batterie in einem Batterienetz mit einem Grenzspannungsniveau ($U_{Gr}$) und einem Mindeststrom ($I_{min}$) bei dem:

   zumindest zu einem ersten Zeitpunkt ($T_1$) mindestens eine erste Strom-SpannungsMessung bei einem ersten Belastungszustand der Batterie durchgeführt und mindestens ein erster Meßpunkt ($M_1$) ermittelt wird,
   zumindest zu einem zweiten Zeitpunkt ($T_2$) mindestens eine zweite Strom-Spannungsmessung bei einem zweiten Belastungszustand der Batterie durchgeführt und mindestens ein zweiter Meßpunkt ($M_2$) ermittelt wird, die Meßpunkte ($M_1$, $M_2$) jeweils bei einem Belastungszustand der Batterie, der größer als 30% der Nennkapazität pro Stunde ($K_N$/h) ist, ermittelt werden,
   durch die Meßpunkte ($M_1$, $M_2$) eine Ausgleichskurve (3) gelegt wird und deren Schnittpunkt ($S_3$) mit dem Grenzspannungsniveau ($U_{Gr}$) ermittelt wird und der zugehörige Grenzstrom ($I_{Gr}$) ermittelt wird,
   durch Differenzbildung zwischen dem Grenzstrom ($I_{Gr}$) und dem Mindeststrom ($I_{min}$) eine Grenzstromreserve als Maß für die in der Batterie verfügbare Restladung ermittelt wird.

2. Verfahren nach Anspruch 1, **dadurch gekennzeichnet, daß** die Ausgleichskurve eine Interpolationsgerade ist.

3. Verfahren nach Anspruch 1, **dadurch gekennzeichnet, daß** die Ausgleichskurve durch die Meßpunkte ($M_1$, $M_2$) aus einer Vielzahl von Meßpunkten gewonnen wird.

4. Verfahren nach Anspruch 3, **dadurch gekennzeichnet, daß** durch die Vielzahl von Meßpunkten eine Ausgleichsgerade gelegt wird.

5. Verfahren nach Anspruch 1, **dadurch gekennzeichnet, daß** die Ausgleichskurve aus der kontinuierlichen Beobachtung der Strom-Spannungskennlinie bestimmt wird und mittels eines Zustandsbeobachters eine Ausgleichsgerade bestimmt wird.

6. Verfahren nach Anspruch 5, **dadurch gekennzeichnet, daß** der Zustandsbeobachter ein Lüenberger-Beobachter oder ein Kalman-Filter ist.

7. Verfahren nach einem der Ansprüche 1 bis 6, **dadurch gekennzeichnet, daß** durch Produktbildung aus dem Grenzspannungsniveau ($U_{Gr}$) und dem Grenzstrom ($I_{Gr}$) ein Maß für eine maximale Leistung ermittelt wird, die der Batterie noch entnommen werden kann, ohne das Grenzspannungsniveau ($U_{Gr}$) zu unterschreiten.

8. Verfahren nach Anspruch 1, **dadurch gekennzeichnet, daß** aus der jeweils aktuellen Grenzstromreserve und der Grenzstromreserve für eine vollgeladene Batterie bei Nennbedingungen ein Verhältnis gebildet wird als ein Maß für die Restladung ($Q_{Rest}$) der Batterie im Verhältnis zur Nennladung.

9. Verfahren nach Anspruch 1, **dadurch gekennzeichnet**, das aus der Grenzstromreserve und der maximalen Grenzstromsteigung ein Verhältnis gebildet wird als Maß für die Restladung ($Q_{Rest}$) der Batterie.

10. Verfahren nach einem der Ansprüche 8 bis 9, **dadurch gekennzeichnet, daß** aus der Restladung ($Q_{Rest}$) der Batterie durch Division mit dem aktuellen Laststrom die Restladezeit der Batterie ermittelt wird.

11. Verfahren nach einem der Ansprüche 1 bis 10, **dadurch gekennzeichnet, daß** es beim Startvorgang von Kraftfahrzeugen durchgeführt wird.

12. Verfahren nach einem der Ansprüche 1 bis 10, **dadurch gekennzeichnet, daß** der Belastungszustand des Bordnetzes durch gezielte Belastungswechsel verändert wird, indem leistungsstarke Verbraucher im Bordnetz ein- und ausgeschaltet werden.

13. Verfahren nach einem der Ansprüche 1 bis 10, **dadurch gekennzeichnet, daß** der Belastungszustand des Bordnetzes gezielt verändert wird, indem die Generatorspannung variiert wird.

**14.** Verfahren nach einem der Ansprüche 1 bis 10, **dadurch gekennzeichnet, daß** der Belastungszustand des Bordnetzes gezielt verändert wird, indem sowohl die Generatorspannung verändert wird als auch leistungsstarke Verbraucher ein- und ausgeschaltet werden.

**Claims**

**1.** Method for monitoring the residual charge and the capacity of a load-carrying battery in a battery system with a limit voltage level ($U_{Gr}$) and a minimum current ($I_{min}$) in which:

at least at an initial time ($T_1$), at least an initial current-voltage measurement is carried out at an initial load state of the battery and at least an initial measuring point ($M_1$) is determined,

at least at a second time ($T_2$), at least a second current-voltage measurement is carried out at a second load state of the battery and at least a second measuring point ($M_2$) is determined,

the measuring points ($M_1$, $M_2$) are each determined at a load state of the battery, which is greater than 30% of the nominal capacity per hour ($K_N$/h),

the measuring points ($M_1$, $M_2$) set a mean curve (3) and the point of intersection ($S_3$) thereof with the limit voltage level ($U_{Gr}$) is determined and the associated limit current ($I_{Gr}$) is determined,

the difference between the limit current ($I_{Gr}$) and the minimum current ($I_{min}$) determines a limit current reserve as the measure for the residual charge available in the battery.

**2.** Method according to claim 1, **characterised in that** the mean curve is an interpolation line.

**3.** Method according to claim 1, **characterised in that** the mean curve through the measuring points ($M_1$, $M_2$) is obtained from a large number of measuring points.

**4.** Method according to claim 3, **characterised in that** a mean straight line is set by the large number of measuring points.

**5.** Method according to claim 1, **characterised in that** the mean curve is determined from the continuous observation of the current-voltage characteristic and a mean straight line is determined by means of a state observer.

**6.** Method according to claim 5, **characterised in that** the state observer is a Luenberger observer or a Kalman filter.

**7.** Method according to any one of claims 1 to 6, **characterised in that** the product of the limit voltage level ($U_{Gr}$) and the limit current ($I_{Gr}$), determines a measure for a maximum output that can still be drawn from the battery without falling below the limit voltage level ($U_{Gr}$).

**8.** Method according to claim 1, **characterised in that** a ratio is formed as a measure for the residual charge ($Q_{residual}$) of the battery in relation to the nominal charge, from the respective effective limit current reserve and the limit current reserve for a fully charged battery at nominal conditions.

**9.** Method according to claim 1, **characterised in that** a ratio is formed as a measure for the residual charge ($Q_{residual}$) of the battery, from the limit current reserve and the maximum limit current slope.

**10.** Method according to either of claims 8 or 9, **characterised in that** the residual charging time of the battery is determined from the residual charge ($Q_{residual}$) of the battery by dividing it with the effective load current.

**11.** Method according to any one of claims 1 to 10, **characterised in that** it is carried out during the starting operation of vehicles.

**12.** Method according to any one of claims 1 to 10, **characterised in that** the load state of the vehicle electrical system is changed by deliberate load changing, by switching powerful loads in the vehicle electrical system on and off.

**13.** Method according to any one of claims 1 to 10, **characterised in that** the load state of the vehicle electrical system is deliberately changed by varying the generator voltage.

**14.** Method according to any one of claims 1 to 10, **characterised in that** the load state of the vehicle electrical system is deliberately changed, both by altering the generator voltage and by switching powerful loads on and off.

**Revendications**

**1.** Procédé pour le contrôle de la charge résiduelle et de la capacité de puissance d'une batterie sollicitée dans un réseau de batterie avec un niveau de tension limite ($U_{Gr}$) et un courant minimum ($I_{min}$) dans lequel :

- au moins une première mesure de tension/courant est effectuée au moins à un premier instant ($T_1$) lors d'un premier état de charge de la batterie et un premier point de mesure ($M_1$) est déterminé,

- au moins une seconde mesure de tension/courant est effectuée à un second instant ($T_2$) lors d'un second état de charge de la batterie et au moins un second point de mesure ($M_2$) est déterminé,

- les points de mesure ($M_1$, $M_2$) sont déterminés respectivement lors d'un état de charge de la batterie qui est supérieur à 30 % de la capacité nominale par heure ($K_N/h$),

- une courbe d'équilibrage (3) est définie par les points de mesure ($M_1$, $M_2$) et leur point d'intersection ($S_3$) avec le niveau de tension limite ($U_{Gr}$) est déterminé et le courant limite ($I_{Gr}$) correspondant est déterminé,

- une réserve de courant limite est déterminée par la formation de la différence entre le courant limite ($I_{Gr}$) et le courant minimum ($I_{min}$) comme référence pour la charge résiduelle disponible dans la batterie.

2. Procédé selon la revendication 1, **caractérisé en ce que** la courbe d'équilibrage est une droite d'interpolation.

3. Procédé selon la revendication 1, **caractérisé en ce que** la courbe d'équilibrage est obtenue par les points de mesure ($M_1$, $M_2$) à partir d'une pluralité de points de mesure.

4. Procédé selon la revendication 3, **caractérisé en ce qu'**une droite d'équilibrage est définie par la pluralité de points de mesure.

5. Procédé selon la revendication 1, **caractérisé en ce que** la courbe d'équilibrage est déterminée à partir de l'observation continue de la courbe caractéristique courant/tension et une droite d'équilibrage est déterminée au moyen d'un observateur d'état.

6. Procédé selon la revendication 5, **caractérisé en ce que** l'observateur d'état est un observateur de Lüenberger ou un filtre de Kalman.

7. Procédé selon l'une quelconque des revendications 1 à 6, **caractérisé en ce qu'**un critère pour une puissance maximale, qui peut être prélevée encore sur la batterie sans passer au-dessous du niveau de tension limite ($U_{Gr}$), est déterminé par la formation du produit résultant du niveau de tension limite ($U_{Gr}$) et du courant limite ($I_{Gr}$).

8. Procédé selon la revendication 1, **caractérisé en ce que**, à partir de la réserve de courant limite actuelle respective et de la réserve de courant limite pour une batterie entièrement chargée dans des conditions nominales, on détermine un rapport comme critère de la charge résiduelle ($Q_{Rest}$) de la batterie par rapport à la charge nominale.

9. Procédé selon la revendication 1, **caractérisé en ce que**, à partir de la réserve de courant limite et de la pente maximale de courant limite, on détermine un rapport comme critère pour la charge résiduelle ($Q_{Rest}$) de la batterie.

10. Procédé selon l'une quelconque des revendications a à 9, **caractérisé en ce** le temps de charge restant de la batterie est déterminé à partir de la charge résiduelle ($Q_{Rest}$) de la batterie par division avec le courant de charge actuel.

11. Procédé selon l'une quelconque des revendications 1 à 10, **caractérisé en ce qu'**il est mis en oeuvre lors de l'opération de démarrage de véhicules automobiles.

12. Procédé selon l'une quelconque des revendications 1 à 10, **caractérisé en ce que** l'état de charge du réseau de bord est modifié par des alternances de charge ciblées en connectant et en déconnectant des consommateurs performants dans le réseau de bord.

13. Procédé selon l'une quelconque des revendications 1 à 10, **caractérisé en ce que** l'état de charge du réseau de bord est modifié de façon ciblée en faisant varier la tension de l'alternateur.

14. Procédé selon l'une quelconque des revendications 1 à 10, **caractérisé en ce que** l'état de charge du réseau de bord est modifié de façon ciblée aussi bien en modifiant la tension de l'alternateur qu'en connectant et déconnectant des consommateurs performants.

Fig. 1